# EUROPÄISCHE PATENTSCHRIFT

(11) **EP 2 305 010 B1**
(45) Veröffentlichungstag und Bekanntmachung des Hinweises auf die Patenterteilung: **05.12.2012**
(21) Anmeldenummer: 09779748.4
(22) Anmeldetag: 15.06.2009
(51) Int. Cl.: H05K 1/02, H05K 7/14

(54) **ELEKTRISCHE SCHALTUNGSANORDNUNG**
ELECTRICAL CIRCUIT ARRANGEMENT
MONTAGE DE CIRCUITS ÉLECTRIQUES

(30) Priorität: 17.07.2008 DE 102008040504
(43) Veröffentlichungstag der Anmeldung: 06.04.2011
(73) Patentinhaber: Robert Bosch GmbH, 70442 Stuttgart (DE)
(72) Erfinder: LISCHECK, Andre, 71665 Vaihingen/Enz (DE); STEIN, Juergen, 75428 Illingen (DE)
(86) Internationale Anmeldenummer: PCT/EP2009/057357
(87) Internationale Veröffentlichungsnummer: WO 2010/006862

(56) Entgegenhaltungen:
- EP-A2- 1 901 397
- US-A- 4 969 827
- US-A- 5 156 552

## Beschreibung

Die Erfindung betrifft eine elektrische Schaltungsanordnung mit einem Grundelement, einer Leiterplatine und einer Befestigungsvorrichtung zum Befestigen der Leiterplatine an dem Grundelement, wobei die Befestigungsvorrichtung die Leiterplatine durch Auftreten des Grundelements auf einer Oberseite und Unterseite der Leiterplatine hält.

### Stand der Technik

Elektrische Schaltungsanordnungen der eingangs genannten Art sind bekannt. Beispielsweise beschreibt die KR-2004042300-A eine Befestigungsvorrichtung, mit der eine Leiterplatine an einem Grundelement befestigt werden kann. Dazu übt eine Schraube von der einen Seite eine Kraft auf die Leiterplatine in Richtung des Grundelements aus, während von der anderen Seite Gegenelemente der Leiterplatine entgegentreten. Auf diese Weise wird die Leiterplatine beabstandet zu dem Grundelement gehalten, ohne dass die von der Schraube auf die Leiterplatine ausgewirkte Kraft die Leiterplatine verbiegt. Wird nun jedoch die elektrische Schaltungsanordnung thermisch belastet, so kann es aufgrund unterschiedlicher Ausdehnungskoeffizienten von Grundelement und Leiterplatine zu thermisch bedingten Materialspannungen kommen. Da die Leiterplatine fest an dem Grundelement befestigt ist, können diese ein Verformen der Leiterplatine hervorrufen. Ist die elektrische Schaltungsanordnung ständig wechselnden Umgebungsbedingungen, also insbesondere einer stetig wechselnden Temperatur ausgesetzt, so kann die Leiterplatine und die auf der Leiterplatte befindlichen Lötstellen durch die ständig wechselnden Materialspannungen und die von diesen hervorgerufenen Verformungen irreparabel beschädigt werden. In diesem Fall muss eine aufwändige Fehleranalyse durchgeführt und häufig die gesamte elektrische Schaltungsanordnung ausgetauscht werden.

EP1901397 A2 zeigt eine Leiterplatte mit einer Kontaktzunge mit mehreren darauf angeordneten Leiterbahnen, die in eine Steckerbuchse gesteckt ist, welche auf einer anderen Leiterplatte befestigt ist.

Das Dokument US 4969827 A zeigt ein elektronisches Modul, das bausteinartig mit weiteren, ähnlich aufgebauten Modulen verbunden werden kann. Dazu sind am Rand des Moduls fingerartige Vorsprünge ausgebildet, die vertikal beabstandet und versetzt zueinander ausgebildet sind. Ein zweites Modul kann zwischen die Finger geschoben werden und wird von ihnen festgehalten und kontaktiert.

Das Dokument US 5156552 A offenbart einen Steckverbinder für eine Leiterplatte. Fingerartige Kontakte werden beim Einschieben der Leiterplatte auseinandergebogen und stellen einen elektrischen Kontakt zu den Leiterbahnen der Leiterplatte her.

### Offenbarung der Erfindung

Die Erfindung ist eine elektrische Schaltungsanordnung mit den in Anspruch 1 genannten Merkmalen. Diese Schaltungsanordnung weist den Vorteil auf, dass die Leiterplatine so an dem Grundelement befestigt ist, dass keine oder nur geringe Materialspannungen in der Leiterplatine auftreten können. Dies wird erreicht, indem Oberseite und Unterseite der Leiterplatine an versetzt zueinander gegenüberliegenden Beaufschlagungsstellen von dem Grundelement unter elastischer Verformung der Leiterplatine beaufschlagt sind. Das bedeutet, dass die Beaufschlagungsstellen auf der Oberseite und Unterseite der Leiterplatine nicht direkt gegenüber liegen. In diesem Fall könnte die Leiterplatine lediglich durch Presskontakt gehalten werden. Dieser muss dabei so ausgelegt werden, dass die Leiterplatine fest gehalten ist, womit auch auftretende Materialspannungen, beispielsweise thermische bedingte Materialspannungen, der Leiterplatine nicht ausgeglichen werden können. Daher ist es erfindungsgemäß vorgesehen, die Beaufschlagungsstellen versetzt zueinander, das heißt nicht direkt gegenüber voneinander liegend, anzuordnen. Auf diese Weise kann das Halten der Leiterplatine an dem Grundelement durch die elastische Verformung der Leiterplatine erreicht werden. Die versetzt zueinander gegenüber liegenden Beaufschlagungsstellen treten also so mit dem Grundelement in Kontakt, dass die Beaufschlagungsstellen in einer Beaufschlagungsrichtung gegeneinander ausgelenkt sind. Durch die elastische Verformung der Leiterplatine ist an jeder Beaufschlagungsstelle eine dem Grundelement entgegen gerichtete Haltekraft vorhanden. Durch diese schwimmende Befestigung der Leiterplatine an dem Grundelement können Verformungen der Leiterplatine durch Materialspannungen ausgeglichen werden. Dabei können sich die Beaufschlagungsstellen gegenüber dem Grundelement verschieben und so dem Entstehen der Materialspannungen entgegenwirken.

Die Erfindung sieht mindestens eine an der Leiterplatine ausgebildete Haltezunge vor, an der mindestens eine Beaufschlagungsstelle vorgesehen ist. Somit tritt nur im Bereich der Haltezunge die elastische Verformung der Leiterplatine auf, während eine restliche Leiterplatinenfläche, welche nicht die Haltezunge aufweist, keiner Verformung unterworfen sein kann.

Auf diese Weise kann die Stelle, an der eine elastische Verformung der Leiterplatine auftritt, gezielt angeordnet werden. Es kann alternativ auch vorgesehen sein, an einer Haltezunge mehrere Beaufschlagungsstellen auszubilden. Auch die Ausbildung von weiteren Haltezungen an einer Haltezunge ist möglich. Über den Querschnitt und/oder die Länge der Haltezunge ist die Haltekraft, also die Kraft, mit der die Haltezunge dem Grundelement entgegentritt, kontrollierbar. Das bedeutet, dass über eine Auslegung der Geometrie der Haltezunge der Sitz der Leiterplatine, also ein Widerstand entgegen einer Verschiebung der Leiterplatine, definiert ist. Die Haltezunge kann beispielsweise eine Zunge aus einem elastischen Material sein, welche an der Leiterplatine befestigt ist. Alternativ kann es auch vorgesehen sein, die Haltezunge aus der Leiterplatine auszubilden.

Die Erfindung sieht vor, dass die Haltezunge durch mindestens einen die Leiterplatine durchsetzenden Freischnitt ausgebildet ist. Die Haltezunge ist also durch die Leiterplatine gebildet. Dabei ist sie durch den Freischnitt von benachbarten Bereichen der Leiterplatine abgetrennt, kann sich diesen gegenüber im Bereich des Freischnitts also frei bewegen. Vorzugsweise ist der Freischnitt so vorzusehen, dass die Haltezunge lediglich mit einer ihrer Kanten mit der übrigen Leiterplatine in Verbindung steht. Diese Kante bildet annäherungsweise eine Drehachse aus, in Bezug zu welcher die elastische Verformung der Leiterplatine beziehungsweise der Haltezunge vorgesehen ist. Über den Freischnitt kann eine beliebige Form der Haltezunge ausgebildet sein. Beispielsweise kann die Haltezunge rechteckig sein. Es kann jedoch auch vorgesehen sein, dass die Haltezunge im Bereich der Beaufschlagungsstelle einen größeren oder einen kleineren Querschnitt aufweist, als an der Kante, an der die Haltezunge mit der restlichen Leiterplatine in Verbindung steht. Da bei der Fertigung der Leiterplatine ein Fräsungsschritt durchgeführt wird, ist für ein Anbringen des Freischnitts kein zusätzlicher Arbeitsschritt notwendig.

Eine Weiterbildung der Erfindung sieht vor, dass zumindest zwei Haltezungen einen gleichen Querschnitt und/oder eine gleiche Länge aufweisen. Die Haltezungen sind insbesondere so ausgebildet, dass eine Auslenkung der Haltezungen, also die elastische Verformung, bei Beaufschlagung durch das Grundelement im Wesentlichen gleich ist. Besonders vorteilhaft ist dies, wenn die zumindest zwei Haltezungen benachbart sind und jeweils auf der Oberseite und der Unterseite der Leiterplatine beaufschlagt sind. Damit erfolgt eine gegenläufige Auslenkung der Haltezungen um eine im Wesentlichen gleiche Strecke.

Eine Weiterbildung der Erfindung sieht vor, dass die Leiterplatine aus einem elastischen Material besteht. Durch die Herstellung der Leiterplatine aus einem elastischen Material kann eine besonders gute Federwirkung der Leiterplatine vorgesehen werden. Dabei können die Elastizität des Materials der Leiterplatine und eine Position der Beaufschlagungsstellen beziehungsweise der Haltezungen aufeinander abgestimmt sein, um eine optimale Befestigung der Leiterplatine an dem Grundelement zu erzielen.

Eine Weiterbildung der Erfindung sieht vor, dass das Grundelement ein Gehäuse ist, in welchem die Leiterplatine zumindest teilweise angeordnet ist. Die Leiterplatine ist also zumindest teilweise in dem Gehäuse angeordnet und dort mittels der Befestigungsvorrichtung unter elastischer Verformung der Leiterplatine gehalten. Dabei kann die Leiterplatine auch vollständig von dem Gehäuse umschlossen sein. Das Gehäuse kann mehrteilig ausgeführt sein und insbesondere einen Gehäusedeckel und einen Gehäuseboden aufweisen. Dabei bilden der Gehäusedeckel und der Gehäuseboden das Grundelement. Die Montage der elektrischen Schaltungsanordnung erfolgt, in dem die Leiterplatine in den Gehäusedeckel oder den Gehäuseboden eingelegt wird. Anschließend werden Gehäusedeckel und Gehäuseboden miteinander verbunden. Durch das Verbinden von Gehäusedeckel und Gehäuseboden drücken diese auf die Beaufschlagungsstellen der Leiterplatine. Damit wird die elastische Verformung der Leiterplatine bewirkt, wodurch die Leiterplatine mittels in dem Gehäuse gehalten ist.

Eine Weiterbildung der Erfindung sieht vor, dass die Leiterplatine beabstandet von einer Gehäusewand des Gehäuses angeordnet ist. Insbesondere ist eine seitliche Beabstandung vorgesehen. Aufgrund des Abstandes zwischen Gehäusewand und Leiterplatine und der schwimmenden Befestigung der Leiterplatine in dem Gehäuse kann sich die Leiterplatine, insbesondere bei Auftreten von Materialspannungen, ausdehnen, ohne in Kontakt mit der Gehäusewand des Gehäuses zu treten. Es wird also vermieden, dass durch das Auftreten der Leiterplatine auf die Gehäusewand trotz der schwimmenden Anordnung der Leiterplatine in dem Gehäuse, in der Leiterplatine Materialspannungen auftreten und diese beschädigen können.

Die Erfindung sieht vor, dass über die Befestigungsvorrichtung eine elektrische Verbindung zwischen mindestens einem an der Beaufschlagungsstelle angeordneten Kontakt und mindestens einem an dem Grundelement vorgesehenen Kontaktmittel hergestellt ist. Über die Befestigungsvorrichtung sind somit elektrische Anschlüsse der Leiterplatine herausgeführt beziehungsweise werden von der Befestigungsvorrichtung abgegriffen. Dabei ist an der Beaufschlagungsstelle der Kontakt vorgesehen, der mit dem Kontaktmittel des Grundelements in Verbindung tritt. Auf diese Weise können beliebig viele Verbindungen von der Leiterplatine auf das Grundelement geführt sein. Die sichere elektrische Verbindung ist über die durch das Auftreten des Grundelements auf die Leiterplatine ausgewirkte Haltekraft gegeben. Diese drückt den Kontakt auf das Kontaktmittel, womit die elektrische Verbindung hergestellt ist.

Eine Weiterbildung der Erfindung sieht vor, dass in der Leiterplatine auftretende Materialspannungen, insbesondere thermische Materialspannungen, durch die Befestigungsvorrichtung kompensierbar sind. Die Befestigungsvorrichtung hält die Leiterplatine also so, dass sie sich insbesondere in seitlicher Richtung ausdehnen und zusammenziehen kann. Auf diese Weise können die in der Leiterplatine vorhandenen Materialspannungen ausgeglichen werden. Ist über die Befestigungsvorrichtung eine elektrische Verbindung zwischen dem Kontakt und dem Kontaktmittel hergestellt, so bleibt diese elektrische Verbindung vorteilhafter Weise auch dann bestehen, wenn sich die Leiterplatine aufgrund der auftretenden Materialspannungen gegenüber dem Grundelement bewegt.

Eine Weiterbildung der Erfindung sieht vor, dass der Kontakt als Kontaktpunkt und/oder Kontaktfläche auf einer Oberfläche der Leiterplatine ausgebildet ist. Beispielsweise kann der Kontakt als Teil einer Leiterbahn der Leiterplatine, die auf der Oberfläche der Leiterplatine einen Kontaktpunkt bildet, ausgebildet sein. Vorteilhaft kann der Kontakt als Kontaktfläche ausgebildet sein. Diese weist im Vergleich zu dem Kontaktpunkt eine größere Oberfläche auf und erlaubt es daher, eine elektrische Verbindung zwischen Kontakt und Kontaktmittel bei einer Verschiebung der Leiterplatine gegenüber dem Grundelement sicherzustellen. Die Kontaktfläche kann ebenso wie der Kontaktpunkt als Teil einer Leiterbahn, also beispielsweise als freigelegt Kupferfläche auf der Oberfläche der Leiterplatine, ausgebildet sein. Es ist ebenso möglich, dass der Kontaktpunkt und/oder die Kontaktfläche eine Ausdehnung in vertikaler Richtung aufweisen. Beispielsweise kann der Kontaktpunkt als Lötstelle mit darauf aufgebrachtem Lötmittel vorgesehen sein. Die Kontaktfläche kann beispielsweise als Platte, insbesondere als Metallplatte, ausgebildet sein und damit eine Ausdehnung in vertikaler Richtung aufweisen.

Eine Weiterbildung der Erfindung sieht vor, dass das Kontaktmittel durch das Grundelement ausgebildet und/oder eine elektrische Masse ist. Es kann vorgesehen sein, dass der Kontakt der Leiterplatine direkt mit dem Grundelement eine elektrische Verbindung herstellt. In diesem Fall kann das Kontaktmittel durch das Grundelement ausgebildet und das Grundelement aus einem leitfähigen Werkstoff, insbesondere Metall, sein. Das Kontaktmittel kann auch eine elektrische Masse darstellen, an die die Leiterplatine angeschlossen ist. Vorteilhaft stellt das Grundelement die elektrische Masse dar und bildet gleichzeitig das Kontaktmittel aus. In diesem Fall tritt die Leiterplatine über den Kontakt mit dem Grundelement und damit der elektrischen Masse in Verbindung, sobald die Leiterplatine durch das Grundelement gehalten ist.

Eine Weiterbildung der Erfindung ist gekennzeichnet durch eine der Leiterplatine zugeordnete Anschlussleiste, über die mindestens eine elektrische Verbindung zu einer an dem Grundelement angeordneten Kontaktleiste herstellbar ist. Die elektrische Verbindung ist also über die Anschlussleiste herstellbar, die in Kontakt mit der Kontaktleiste des Grundelements, beispielsweise durch Einstecken oder Aufstecken, tritt. Die Kontaktleiste und die Anschlussleiste können eine beliebige Anzahl von Anschlüssen aufweisen, so dass mindestens eine elektrische Verbindung herstellbar ist. Anschlussleiste und/oder Kontaktleiste können dabei federnde Anschlüsse aufweisen, so dass auch Anschlussleiste und Kontaktleiste gegeneinander verschoben werden dürfen, beispielsweise zum Ausgleich von Materialspannungen, während die elektrische Verbindung aufrechterhalten wird. Es kann aber auch vorgesehen sein, dass Anschlussleiste und Kontaktleiste starr miteinander verbunden sind. In diesem Fall ist vorzugsweise lediglich auf einer Seite der Leiterplatine eine Anschlussleiste vorzusehen, um den Ausgleich von Materialspannungen durch eine Bewegung der Leiterplatine zu ermöglichen.

### Kurze Beschreibung der Zeichnungen

Die Erfindung wird im Folgenden anhand der in der Zeichnung dargestellten Ausführungsbeispiele näher erläutert, ohne dass eine Beschränkung der Erfindung erfolgt. Es zeigen:
- Figur 1: eine Leiterplatine mit einer Anschlussleiste und Beaufschlagungsstellen,
- Figur 2: einen Ausschnitt der Leiterplatine mit auf Haltezungen angeordneten Beaufschlagungsstellen, und
- Figur 3: ein Gehäuse mit darin angeordneter Leiterplatine.

### Ausführungsform(en) der Erfindung

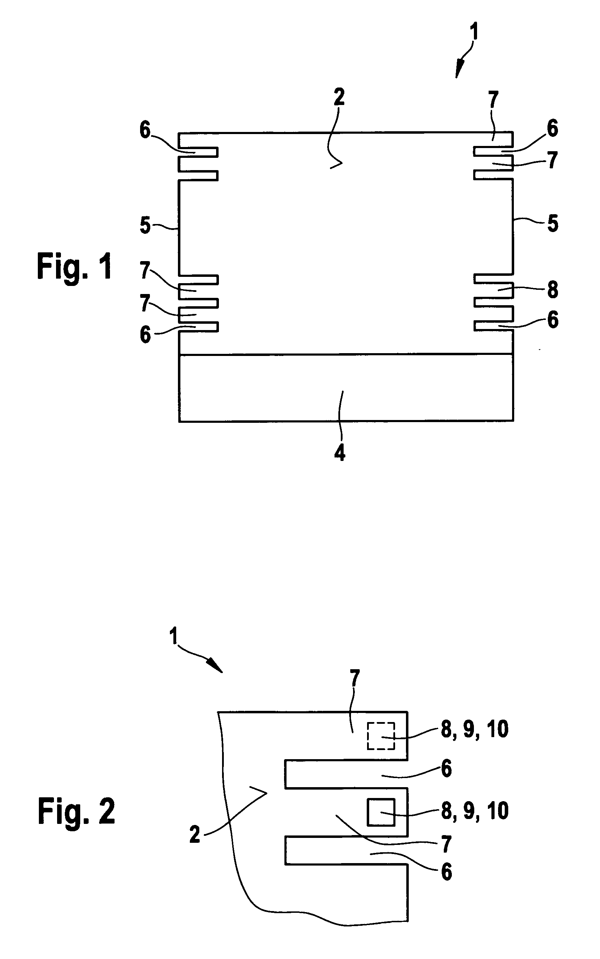

Die Figur 1 zeigt eine Leiterplatine 1 mit einer Oberseite 2 und einer Unterseite 3 (In Figur 1 nicht erkennbar). Die Leiterplatine 1 ist im Wesentlichen rechteckig ausgebildet. Sie weist auf einer Seite eine Anschlussleiste 4 zur Herstellung einer elektrischen Verbindung auf. Ausgehend von Seitenkanten 5 der Leiterplatine 1 ist die Leiterplatine 1 von Freischnitten 6 durchsetzt, wodurch Haltezungen 7 ausgebildet sind. Die Haltezungen 7 sind gegenüber der durch die Leiterplatine 1 ausgebildeten Ebene in senkrechter Richtung elastisch auslenkbar. In dem in Figur 1 dargestellten Beispiel sind jeweils zwei Haltezungen 7 nebeneinander angeordnet. Diese sind so ausgebildet, dass sie sowohl die gleiche Länge als auch den gleichen Querschnitt aufweisen. Auf den Haltezungen 7 sind Beaufschlagungsstellen 8 angeordnet, die der Befestigung der Leiterplatine 1 dienen. Auf benachbarten Haltezungen 7 ist jeweils eine Beaufschlagungsstelle 8 der Oberseite 2, eine weitere Beaufschlagungsstelle 8 der Unterseite 3 der Leiterplatine 1 zugeordnet.

Figur 2 zeigt einen Ausschnitt der Leiterplatine 1 mit zwei Haltezungen 7. Die Haltezungen 7 sind auf die beschriebene Weise durch Freischnitte 6 in der Leiterplatine 1 ausgebildet. Eine Haltezunge 7 weist eine Beaufschlagungsstelle 8 auf der Oberseite 2 der Leiterplatine 1 auf, die andere Haltezunge 7 auf der Unterseite 3. An den Beaufschlagungsstellen 8 ist jeweils ein Kontakt 9 vorgesehen, der als Kontaktfläche 10 ausgebildet ist.

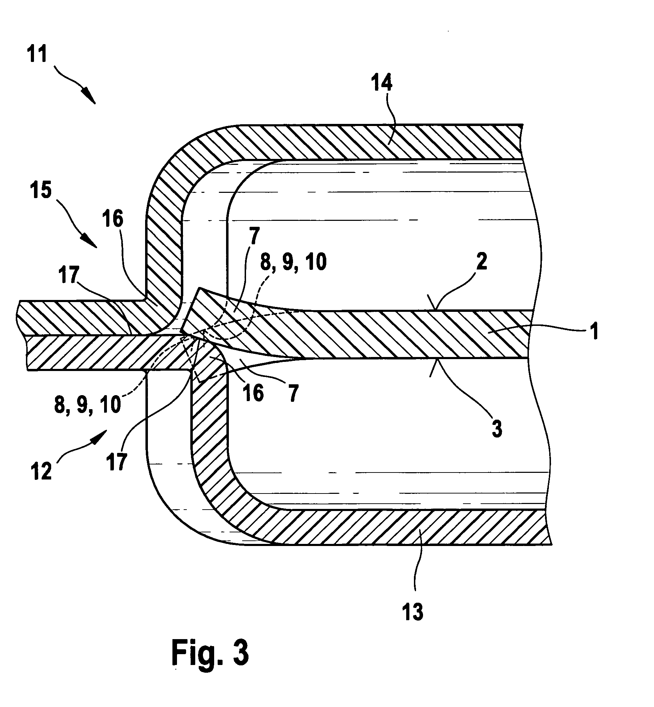

Die Figur 3 zeigt eine elektrische Schaltungsanordnung 11 mit einer Leiterplatine 1 und einem Gehäuse 12, welches aus Gehäuseboden 13 und Gehäusedeckel 14 besteht. Die Leiterplatine 1 ist durch eine Befestigungsvorrichtung 15 an einem Grundelement 16, welches in dem dargestellten Beispiel das Gehäuse 12 ist, befestigt. Die Befestigung erfolgt derart, dass das Grundelement 16 mit einer Beaufschlagungsstelle 8 auf einer Haltezunge 7 der Leiterplatine 1 auf der Unterseite 3 der Leiterplatine 1 in Kontakt tritt und die Haltezunge 7 nach oben auslenkt. Gleichzeitig tritt das Grundelement 16 in Kontakt mit der benachbarten Haltezunge 7 beziehungsweise deren Beaufschlagungsstelle 8 und lenkt die Haltezunge 7 nach unten aus. Dabei treten die Kontaktflächen 10 der Beaufschlagungsstellen 8 in Kontakt mit Kontaktmitteln 17 des Grundelements 16. Über diese Verbindung steht die Leiterplatine 1 in elektrischem Kontakt mit dem Gehäuse 12, welches eine elektrische Masse darstellt. Weiterhin kann die Leiterplatine 1 über die Anschlussleiste 4 in Kontakt mit einer nicht dargestellten Kontaktleiste stehen, die dem Grundelement 16 beziehungsweise dem Gehäuse 12 zugeordnet ist. Die Leiterplatine 1 ist aus einem elastischen Material hergestellt. Damit ist eine Auslenkung der Haltezungen 7 auf einfache Weise möglich und die Leiterplatine 1 somit in dem Gehäuse 12 mittels der Befestigungsvorrichtung 15 befestigbar. Durch diese Befestigung ist die Leiterplatine 1 so in dem Gehäuse 12 gehalten, dass die Leiterplatine 1 Materialspannungen, insbesondere durch Temperaturbeaufschlagung hervorgerufene Materialspannungen, ohne Weiteres ausgleichen kann, indem sich mindestens eine der Beaufschlagungsstellen 8 in Bezug zu dem Grundelement 16 beziehungsweise dem Gehäuse 12 verschiebt.

## Patentansprüche

1. Elektrische Schaltungsanordnung (11) mit einem Grundelement (16), einer Leiterplatine (1) und einer Befestigungsvorrichtung (15) zum Befestigen der Leiterplatine (1) an dem Grundelement (16), wobei die Befestigungsvorrichtung (15) Beaufschlagungsstellen (8) umfasst, die an der Oberseite (2) und an der Unterseite (3) der Leiterplatine (1) ausgebildet sind, wobei das Grundelement (16) mit der Leiterplatine (1) an den Beaufschlagungsstellen (8) in Kontakt tritt, und wobei die Beaufschlagungsstellen (8) auf der Oberseite (2) der Leiterplatine (1) versetzt gegenüber den Beaufschlagungsstellen (8) auf der Unterseite (3) der Leiterplatine (1) angeordnet sind, wobei mindestens eine an der Leiterplatine (1) ausgebildete Haltezunge (7), an der mindestens eine Beaufschlagungsstelle (8) vorgesehen ist, durch mindestens einen die Leiterplatine (1) durchsetzenden Freischnitt (6) ausgebildet ist, wobei eine Haltezunge (7) eine Beaufschlagungsstelle (8) auf der Oberseite (2) der Leiterplatine (1) aufweist, eine andere Haltezunge (7) eine Beaufschlagungsstelle (8) auf der Unterseite (3) der Leiterplatine (1) aufweist
**dadurch gekennzeichnet, dass** an den Beaufschlagungsstellen (8) jeweils ein Kontakt (9) vorgesehen ist, wobei über die Befestigungsvorrichtung (15) eine elektrische Verbindung zwischen dem jeweiligen an den Beaufschlagungsstellen (8) angeordneten Kontakt (9) und mindestens einem an dem Grundelement (16) vorgesehenen Kontaktmittel (17) hergestellt ist.

2. Elektrische Schaltungsanordnung nach Anspruch 1, **dadurch gekennzeichnet, dass** zumindest zwei Haltezungen (7) einen gleichen Querschnitt und/oder eine gleiche Länge aufweisen.

3. Elektrische Schaltungsanordnung nach einem der Ansprüche 1 oder 2, **dadurch gekennzeichnet, dass** die Leiterplatine (1) aus einem elastischen Material besteht.

4. Elektrische Schaltungsanordnung nach einem oder mehreren der vorhergehenden Ansprüche, **dadurch gekennzeichnet, dass** das Grundelement (16) ein Gehäuse (12) ist, in welchem die Leiterplatine (1) zumindest teilweise angeordnet ist.

5. Elektrische Schaltungsanordnung nach einem oder mehreren der vorhergehenden Ansprüche, **dadurch gekennzeichnet, dass** die Leiterplatine (1) beabstandet von einer Gehäusewand des Gehäuses (12) angeordnet ist.

6. Elektrische Schaltungsanordnung nach einem oder mehreren der vorhergehenden Ansprüche, **dadurch gekennzeichnet, dass** in der Leiterplatine (1) auftretende Materialspannungen, insbesondere thermische Materialspannungen, durch die Befestigungsvorrichtung (15) kompensierbar sind.

7. Elektrische Schaltungsanordnung nach einem oder mehreren der vorhergehenden Ansprüche, **dadurch gekennzeichnet, dass** der Kontakt (9) als Kontaktpunkt und/oder Kontaktfläche (10) auf einer Oberfläche der Leiterplatine (1) ausgebildet ist.

8. Elektrische Schaltungsanordnung nach einem oder mehreren der vorhergehenden Ansprüche, **dadurch gekennzeichnet, dass** das Kontaktmittel (17) durch das Grundelement (16) ausgebildet und/oder eine elektrische Masse ist.

9. Elektrische Schaltungsanordnung nach einem oder mehreren der vorhergehenden Ansprüche, **gekennzeichnet durch** eine der Leiterplatine (1) zugeordnete Anschlussleiste (4), über die mindestens eine elektrische Verbindung zu einer an dem Grundelement (16) angeordneten Kontaktleiste herstellbar ist.

## Claims

1. Electrical circuit arrangement (11) having a base element (16), a printed circuit board (1) and a fastening apparatus (15) for fastening the printed circuit board (1) to the base element (16), with the fastening apparatus (15) comprising application points (8) which are formed on the upper face (2) and on the lower face (3) of the printed circuit board (1), with the base element (16) coming into contact with the printed circuit board (1) at the application points (8), and with the application points (8) on the upper face (2) of the printed circuit board (1) being arranged offset in relation to the application points (8) on the lower face (3) of the printed circuit board (1), with at least one retaining tongue (7), which is formed on the printed circuit board (1) and on which at least one application point (8) is provided, being formed by at least one clearance (6) which passes through the printed circuit board (1), with one retaining tongue (7) having an application point (8) on the upper face (2) of the printed circuit board (1), another retaining tongue (7) having an application point (8) on the lower face (3) of the printed circuit board (1), **characterized in that** a contact (9) is provided on each of the application points (8), with an electrical connection being established between the respective contact (9), which is arranged on the application points (8), and at least one contact means (17), which is provided on the base element (16), by means of the fastening apparatus (15).

2. Electrical circuit arrangement according to Claim 1, **characterized in that** at least two retaining tongues (7) have an identical cross section and/or an identical length.

3. Electrical circuit arrangement according to either of Claims 1 and 2, **characterized in that** the printed circuit board (1) is composed of an elastic material.

4. Electrical circuit arrangement according to one or more of the preceding claims, **characterized in that** the base element (16) is a housing (12) in which the printed circuit board (1) is at least partially arranged.

5. Electrical circuit arrangement according to one or more of the preceding claims, **characterized in that** the printed circuit board (1) is arranged at a distance from a housing wall of the housing (12).

6. Electrical circuit arrangement according to one or more of the preceding claims, **characterized in that** material stresses which occur in the printed circuit board (1), in particular thermal material stresses, can be compensated for by the fastening apparatus (15).

7. Electrical circuit arrangement according to one or more of the preceding claims, **characterized in that** the contact (9) is formed as a contact point and/or contact area (10) on a surface of the printed circuit board (1).

8. Electrical circuit arrangement according to one or more of the preceding claims, **characterized in that** the contact means (17) is formed by the base element (16) and/or is an electrical earth.

9. Electrical circuit arrangement according to one or more of the preceding claims, **characterized by** a terminal strip (4) which is associated with the printed circuit board (1) and by means of which at least one electrical connection to a contact strip, which is arranged on the base element (16), can be established.

## Revendications

1. Agencement de montage électrique (11) comprenant un élément de base (16), une carte à circuits imprimés (1) et un dispositif de fixation (15) pour la fixation de la carte à circuits imprimés (1) à l'élément de base (16), le dispositif de fixation (15) comprenant des zones de sollicitation (8) qui sont réalisées sur le côté supérieur (2) et sur le côté inférieur (3) de la carte à circuits imprimés (1), l'élément de base (16) venant en contact avec la carte à circuits imprimés (1) au niveau des zones de sollicitation (8), et les zones de sollicitation (8) sur le côté supérieur (2) de la carte à circuits imprimés (1) étant disposées de manière décalée par rapport aux zones de sollicitation (8) sur le côté inférieur (3) de la carte à circuits imprimés (1), au moins une langue de retenue (7) réalisée au niveau de la carte à circuits imprimés (1), sur laquelle au moins une zone de sollicitation (8) est prévue, étant réalisée par au moins un évidement (6) traversant la carte à circuits imprimés (1), une langue de retenue (7) présentant une zone de sollicitation (8) sur le côté supérieur (2) de la carte à circuits imprimés (1), une autre langue de retenue (7) présentant une zone de sollicitation (8) sur le côté inférieur (3) de la carte à circuits imprimés (1),
**caractérisé en ce qu'**un contact respectif (9) est prévu au niveau des zones de sollicitation (8), une connexion électrique entre le contact respectif (9) disposé sur les zones de sollicitation (8) et au moins un moyen de contact (17) prévu sur l'élément de base (16) étant établie par le biais du dispositif de fixation (15).

2. Agencement de montage électrique selon la revendication 1, **caractérisé en ce qu'**au moins deux langues de retenue (7) présentent une section transversale identique et/ou une longueur identique.

3. Agencement de montage électrique selon l'une quelconque des revendications 1 ou 2, **caractérisé en ce que** la carte à circuits imprimés (1) se compose d'un matériau élastique.

4. Agencement de montage électrique selon l'une quelconque ou plusieurs des revendications précédentes, **caractérisé en ce que** l'élément de base (16) est un boîtier (12) dans lequel est disposée au moins en partie la carte à circuits imprimés (1).

5. Agencement de montage électrique selon l'une quelconque ou plusieurs des revendications précédentes, **caractérisé en ce que** la carte à circuits imprimés (1) est disposée à distance d'une paroi de boîtier du boîtier (12).

6. Agencement de montage électrique selon l'une quelconque ou plusieurs des revendications précédentes, **caractérisé en ce que** les contraintes de matériau se produisant dans la carte à circuits imprimés (1), notamment les contraintes thermiques du matériau, peuvent être compensées par le dispositif de fixation (15).

7. Agencement de montage électrique selon l'une quelconque ou plusieurs des revendications précédentes, **caractérisé en ce que** le contact (9) est réalisé sous forme de point de contact et/ou de surface de contact (10) sur une surface de la carte à circuits imprimés (1).

8. Agencement de montage électrique selon l'une quelconque ou plusieurs des revendications précédentes, **caractérisé en ce que** le moyen de contact (17) est réalisé par l'élément de base (16) et/ou est une masse électrique.

9. Agencement de montage électrique selon l'une quelconque ou plusieurs des revendications précédentes, **caractérisé par** une barrette de connexion (4) associée à la carte à circuits imprimés (1), par le biais de laquelle au moins une connexion électrique peut être établie avec une barre de contact disposée sur l'élément de base (16).
